# EUROPEAN PATENT APPLICATION

(11) **EP 4 660 991 A1**
(43) Date of publication of application: **10.12.2025**
(21) Application number: 24750523.3
(22) Date of filing: 29.01.2024
(51) Int. Cl.: G09G 3/36, G09G 3/3275, H03F 3/45

(54) **DIFFERENTIAL AMPLIFIER AND DATA DRIVER**

(30) Priority: 01.02.2023 KR 20230013398
(71) Applicant: LX Semicon Co., Ltd., Daejeon 34027 (KR)
(72) Inventor: YU, Sang Duk, Daejeon 34027 (KR); PARK, Ho Jong, Daejeon 34027 (KR); AHN, Tae Jun, Daejeon 34027 (KR); YEO, Sung Dae, Daejeon 34027 (KR)
(74) Representative: Ter Meer Steinmeister & Partner
(86) International application number: PCT/KR2024/001363
(87) International publication number: WO 2024/162725

(57) **Abstract**

An embodiment relates to a data driver for driving pixels of a display panel, and a differential amplifier that can be applied to the data driver. Provided in an embodiment is a technique of improving, through a boosting circuit, a dynamic current to both of a first transistor and a second transistor of the differential amplifier so as to improve the slew rate of the differential amplifier.

## Description

### [Technical Field]

The embodiment relates to a differential amplifier and a data driving device.

### [Background Art]

A plurality of pixels can be arranged on a display panel. The pixels can control brightness using a backlight and a liquid crystal, and can control brightness by controlling the amount of power flowing to a self-light-emitting element such as an Organic Light Emitting Diode (OLED).

The display device can include a driving device that can control brightness of each pixel. The driving device can control brightness of each pixel by controlling the degree of opening and closing of the liquid crystal or controlling the amount of power supplied to the self-light-emitting element.

The driving device can supply data voltage corresponding to the gray level value of each pixel to each pixel. Each pixel can control the degree of opening and closing of the liquid crystal or control the amount of power supplied to the self-light-emitting element according to the data voltage. In terms of supplying data voltage, the aforementioned driving device is also called a data driving device. Meanwhile, each pixel may include a driving transistor, and the data voltage may be supplied to the source terminal of the driving transistor. In this respect, the data driving device may also be called a source driver. In addition, the data driving device may drive a plurality of pixels in which one channel constitutes a vertical line. In this respect, the data driving device may also be called a column driver.

The data driving device may drive one line per horizontal line at a predetermined horizontal time. For example, the data driving device may drive the pixels of the first horizontal line during a first horizontal time, and drive the pixels of the second horizontal line during a second horizontal time following the first horizontal time.

The data driving device may change the size of the data voltage supplied to the display panel according to the gray level value of each line pixel at one point in time for each horizontal time. For example, the data driving device may supply the first data voltage to the display panel during the first horizontal time, and then change the first data voltage to the second data voltage at the start of the second horizontal time and supply it to the display panel.

The data driving device may receive image data from the data processing device. Image data may include pixel data representing the gray level value of each pixel. The data driving device may convert the pixel data into an analog voltage and amplify the analog voltage to generate a data voltage.

The data driving device may amplify the analog voltage and generate the data voltage using a differential amplifier. In this structure, the quality of the image displayed on the display panel may be greatly affected by the slew rate of the differential amplifier. If the slew rate is low, the grayscale of the pixel may not reach the desired level within a given time, and the response characteristics of the display panel may be reduced.

### [Disclosure]

### [Technical Problem]

The embodiment aims to solve the above-mentioned problem and other problems.

Another object of the embodiment is to provide a technology for improving the response characteristics of the display panel by improving the data driving device.

Another object of the embodiment is to provide a technology for improving the slew rate of a differential amplifier that can be used in the data driving device.

### [Technical Solution]

According to one aspect of the embodiment to achieve the above or other purposes, a differential amplifier may include a first circuit stage including a first output transistor connected between a first voltage rail and an output terminal, and a second output transistor connected between a second voltage rail and the output terminal; a second circuit stage configured to generate first differential currents and second differential currents based on differential input voltages; a third circuit stage configured to control a gate voltage of the first output transistor based on the first differential currents; a fourth circuit stage configured to control a gate voltage of the second output transistor based on the second differential currents; and a fifth circuit stage configured to add dynamic currents to the first and second differential currents in response to variations in the differential input voltages.

According to another aspect of the embodiment, the data driving device may include a latch circuit configured to latch pixel data including a gray level value for a pixel; a digital-to-analog converter configured to convert a digital signal corresponding to the pixel data into an analog voltage; and a buffer circuit: including a rail-to-rail class-AB type amplifier having a first differential amplifier circuit and a second differential amplifier circuit, each having gate terminals to which differential input voltages are inputted, connected to an input circuit stage, and configured to generate a data voltage amplifying the analog voltage using the amplifier, to supply the data voltage to the pixel, and to supply dynamic currents to the first and second differential amplifier circuits in response to variations in the analog voltage.

### [Advantageous Effects]

As described above, according to the embodiment, the response characteristics of the display panel can be improved through improvements to the data driving device.

According to the embodiment, the slew rate of the differential amplifier that can be used in the data driving device can be improved.

According to the embodiment, a differential amplifier having a high-speed slew rate can be provided without adding static power.

According to the embodiment, a differential amplifier in which the phenomenon of overshooting and undershooting is improved in the range of linear operation can be provided.

According to an embodiment, a differential amplifier performing an effective slew boosting function can be provided by adding a simple circuit.

### [Brief description of Drawings]

FIG. 1 is a configuration diagram of a display device according to an embodiment.
FIG. 2 is a configuration diagram of a data driving device according to an embodiment.
FIG. 3 is a configuration diagram of a differential amplifier according to an embodiment.
FIG. 4 is a configuration diagram of a first example of a boosting circuit stage according to an embodiment.
FIG. 5 is a configuration diagram of a second example of a boosting circuit stage according to an embodiment.
FIG. 6 is a diagram illustrating a main current state of a differential amplifier for a rising waveform when a boosting circuit stage according to a second example is turned off.
FIG. 7 is a diagram illustrating a main current state of a differential amplifier for a rising waveform when a boosting circuit stage according to a second example is turned on.
FIG. 8 is a diagram illustrating the main current state of the differential amplifier for the falling waveform when the boosting circuit stage according to the second example is turned off.
FIG. 9 is a diagram illustrating the main current state of the differential amplifier for the falling waveform when the boosting circuit stage according to the second example is turned on.

### [Best Mode]

Hereinafter, the embodiments disclosed in this specification will be described in detail with reference to the attached drawings, and the same or similar components will be given the same reference numbers regardless of the drawing symbols, and redundant descriptions thereof will be omitted. The suffixes 'module' and 'part' for components used in the following description are given or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. Additionally, when an element such as a layer, region or substrate is referred to as being 'on' another element, this includes that it may be directly on the other element or that other intermediate elements may be present in between.

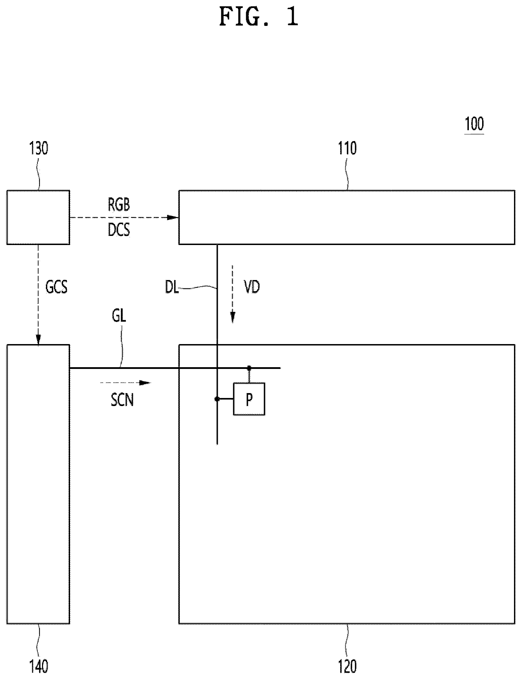

FIG. 1 is a configuration diagram of a display device according to an embodiment.

Referring to FIG. 1, the display device 100 may include a display panel 120, a data processing device 130, a gate driving device 140, a data driving device 110, etc.

The display panel 120 may be a liquid crystal display panel, and may be a self-luminous panel such as an OLED panel.

When the display panel 120 is a liquid crystal display panel, the display panel 120 may include a backlight, a liquid crystal, a common electrode, etc. Each pixel P may include a pixel electrode, a driving transistor, etc. When a scan signal is supplied to the gate terminal of the driving transistor, the driving transistor may be turned on and a data voltage may be supplied to the pixel electrode. When an electric field is formed between the pixel electrode and the common electrode according to the data voltage, the alignment direction of the liquid crystal changes, and accordingly, the transmittance of light supplied from the backlight changes, so that the brightness of the pixel may be adjusted.

A plurality of data lines DL and a plurality of gate lines GL may be arranged in a matrix form on the display panel 120. The data line DL may be connected to the source terminal of the driving transistor of each pixel P, and the gate line GL may be connected to the gate terminal of the driving transistor of each pixel P. When a scan signal SCN is supplied to the gate line GL, the driving transistor is turned on, and the data voltage VD supplied through the data line DL may be transmitted to the pixel electrode.

A parasitic capacitor may be formed on the data line DL. The parasitic capacitor may be formed between the data line DL and the common electrode or between the data line DL and the pixel electrode. The data driving device 110 that supplies the data voltage VD may recognize the parasitic capacitor as a load. The larger the capacity of the parasitic capacitor, the more power the data driving device 110 can supply to the data line DL.

The display panel 120 may be a self-luminous panel such as an OLED panel. In addition to the OLED panel, the self-luminous panel may also use other types of panels such as a micro LED panel.

Each pixel P of the OLED panel may include a scan transistor, a driving transistor, an OLED, etc. When a scan signal SCN is supplied to the gate terminal of the scan transistor, the scan transistor is turned on and the data voltage VD can be supplied to the driving transistor through the scan transistor. In the OLED panel, the data voltage VD can be supplied to the gate terminal of the driving transistor. The size of the conduction current (or driving current) of the driving transistor is determined according to the size of the data voltage VD, and the brightness of the OLED connected to the driving transistor can be controlled according to the size of the conduction current of the driving transistor.

A plurality of data lines DL and a plurality of gate lines GL may be arranged in a matrix form on the display panel 120. The data line DL may be connected to the source terminal of the scan transistor of each pixel P, and the gate line GL may be connected to the gate terminal of the source transistor of each pixel P. When a scan signal SCN is supplied to the gate line GL, the scan transistor is turned on, and the data voltage VD supplied through the data line DL may be transmitted to the driving transistor.

A parasitic capacitor may be formed on the data line DL. The parasitic capacitor may be formed between the data line DL and the cathode electrode of the OLED, or between the data line DL and the anode electrode of the OLED. From the perspective of the data driving device 110 that supplies the data voltage VD, the parasitic capacitor may be recognized as a load. The larger the capacity of the parasitic capacitor, the more power the data driving device 110 can supply to the data line.

The data processing device 130 can receive image data from an external device - for example, a host or a device called an AP (Application Processor). The image data in the format of the external device can be converted into image data RGB in a format that the data driving device 110 can process. The data processing device 130 can transmit the converted image data RGB to the data driving device 110.

The image data RGB can include pixel data representing a gray level value for each pixel P. The pixel data for one pixel P can be, for example, data having 8 bits and can express a gray level value from 0 to 255. The data processing device 130 can generate pixel data for each pixel P and transmit the pixel data to the data driving device 110 by including the pixel data in the image data RGB.

The data processing device 130 can transmit control signals DCS, GCS to devices involved in driving the display panel 120 - for example, the data driving device 110 and the gate driving device 140. The data processing device 130 can transmit the data control signal DCS to the data driving device 110 and the gate control signal GCS to the gate driving device 140.

The control signals DCS, GCS can include setting information for each device. For example, the data processing device 130 can receive setting information from external devices, check the setting information for each device, and then transmit the setting information by including it in the corresponding control signal DCS or GCS.

The control signals DCS, GCS may include timing signals for controlling each device. The timing signals may be, for example, vertical synchronization signals, horizontal synchronization signals, etc. The data driving device 110 or the gate driving device 140 may distinguish frames according to the timing signals and may distinguish each horizontal time. In terms of controlling the timing of each device, the data processing device 130 is also called a timing controller.

The gate driving device 140 may supply a scan signal SCN to pixels P on the display panel 120. Pixels supplied with a scan signal SCN indicating turn-on may be selected, and a data voltage VD may be supplied to the selected pixels.

The gate driving device 140 may supply a scan signal SCN through a gate line GL. A plurality of gate lines GL may be arranged on the display panel 120. Each gate line GL can be connected to pixels P arranged in a row in one direction-for example, in a horizontal direction. The gate driving device 140 can supply a scan signal SCN indicating a turn-on to one of the plurality of gate lines GL, and pixels P connected to the corresponding gate line GL can be selected. The gate driving device 140 can supply a scan signal SCN indicating a turn-on while changing the gate line GL at each horizontal time.

The data driving device 110 can drive pixels P on the display panel 120.

The data driving device 110 can receive image data RGB from the data processing device 130. The data driving device 110 can check pixel data for each pixel P included in the image data RGB, generate a data voltage VD corresponding to the pixel data, and supply it to each pixel P through the data line DL.

The pixel data can represent a gray level value for each pixel P. The data driving device 110 can generate a data voltage VD corresponding to the gray level value.

The pixel data can be stored in the latch circuit of the data driving device 110 and then output in the form of a digital signal. The data driving device 110 can convert a digital signal into an analog voltage, i.e., a data voltage VD, using gamma reference voltages.

There is a difference between the grayscale corresponding to physical brightness and the grayscale corresponding to brightness perceived by a human. Correcting this difference is called gamma conversion. When the data driving device 110 converts a digital signal into an analog voltage, it can also apply gamma conversion at the same time. For example, the data driving device 110 can apply digital-to-analog converting and gamma conversion simultaneously by using the voltages used for digital-to-analog converting as voltages to which gamma conversion is applied - gamma reference voltages.

The analog voltage may not be suitable for driving the pixel P because of its low power level (or voltage level). Therefore, the data driving device 110 can amplify the analog voltage to generate a data voltage VD and supply the data voltage VD with a relatively high power level to the pixel P.

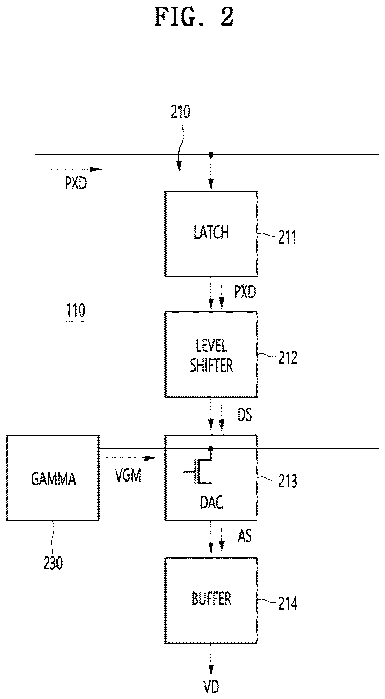

FIG. 2 is a configuration diagram of a data driving device according to an embodiment.

Referring to FIG. 1 and FIG. 2, the data driving device 110 may include a channel circuit 210, a gamma reference voltage generation circuit 230, etc.

The channel circuit 210 may include a latch circuit 211, a level shifter 212, a digital-to-analog converter (DAC, 213), a buffer circuit 214, etc., and may receive pixel data PXD corresponding to the gray level value of the pixel P, generate a data voltage VD, and supply the data voltage VD to a data line DL connected to the pixel P.

The latch circuit 211 may sequentially store pixel data PXD received through a data bus line.

The latch circuit 211 may have two latches inside. The first latch can store pixel data to be output at the next horizontal time, and the second latch can store pixel data to be output at the current horizontal time. When the next horizontal time comes, the first latch can store pixel data to be output at the next horizontal time, and the pixel data stored in the first latch can be moved to the second latch and stored.

The output timing of the latch circuit 211 can be determined according to the latch output signal generated at each horizontal time. The latch output signal can be synchronized with the horizontal synchronization signal. The latch output signal can be a signal whose phase is different from that of the horizontal synchronization signal but whose period length is the same.

The latch circuit 211 can transfer pixel data PXD stored in the latch circuit 211 to the level shifter 212 according to the latch output signal.

The level shifter 212 can convert the pixel data PXD into a digital signal DS. The level shifter 212 can increase the power level while converting the pixel data PXD into a digital signal DS.

The pixel data PXD can be a signal with a low voltage or power level. The level shifter 212 can convert the pixel data PXD into a digital signal DS with a high power level.

The DAC 213 can receive the digital signal DS and drive the gate terminals of the internal switches. The DAC 213 can convert the digital signal DS into an analog voltage AS by driving the gates of the switches.

The DAC 213 can include a plurality of switches. Depending on the on/off state, the switches can selectively connect one of the plurality of gamma reference voltage lines to which the plurality of gamma reference voltages are supplied to an output terminal, i.e., an input terminal of the buffer circuit 214. The voltage formed on the selected one gamma reference voltage line can be an analog voltage AS to be supplied to the buffer circuit 214. The digital signal DS can change the on/off state of the switches while being supplied to the gate terminals of the switches.

The digital signal DS can be supplied to drive the gate terminals of the switches. The digital signal DS is output by the level shifter 212, and from this perspective, the gate load of the switches can be part of the output load of the level shifter 212.

The data driving device 110 can include a gamma reference voltage generation circuit 230 that supplies gamma reference voltages VGM to the DAC 213.

The channel circuit 210 can include a buffer circuit 214 connected between the output terminal of the DAC 213 and the pixel P.

The buffer circuit 214 can amplify the output voltage of the DAC 213 and supply it to the data line DL connected to the pixel P. The buffer circuit 214 can amplify the analog voltage AS to generate the data voltage VD and supply the data voltage VD to the data line DL.

The buffer circuit 214 can include a differential amplifier for amplifying the analog voltage AS to the data voltage VD.

The differential amplifier can be a rail-to-rail class-AB (type amplifier). The buffer circuit 214 can generate the data voltage VD by amplifying the analog voltage AS using the differential amplifier.

The differential amplifier can be connected to input and output as a buffer structure. For example, the output terminal of the differential amplifier can be connected to the minus input terminal of the differential amplifier. The analog voltage AS can be supplied to the plus input terminal of the differential amplifier.

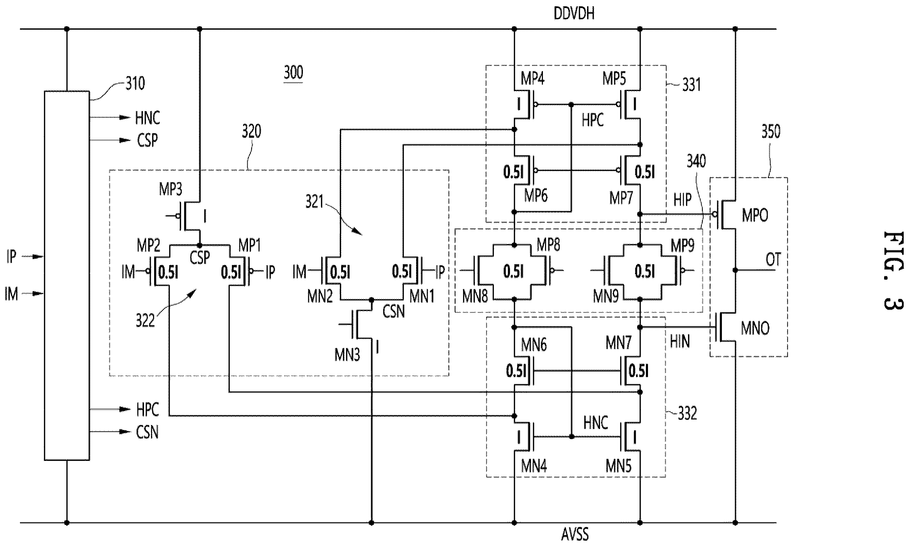

FIG. 3 is a configuration diagram of a differential amplifier according to an embodiment.

Referring to FIG. 3, the differential amplifier 300 may include a first circuit stage 350, a second circuit stage 320, a third circuit stage 331, a fourth circuit stage 332, a fifth circuit stage 310, a sixth circuit stage 340, etc.

The first circuit stage 350 may include a first output transistor MPO connected between a first voltage rail DDVDH and an output terminal OT and a second output transistor MNO connected between a second voltage rail AVSS and the output terminal OT. The first circuit stage 350 may be referred to as an output circuit stage as a circuit including an output terminal OT. Hereinafter, the first circuit stage 350 will be referred to as an output circuit stage and the embodiment will be described.

The second circuit stage 320 may be referred to as an input circuit stage as a circuit that generates differential currents according to differential input voltages. Hereinafter, the second circuit stage 320 will be referred to as an input circuit stage and an embodiment will be described.

The third circuit stage 331 may be a circuit that controls the gate voltage of the first output transistor MPO according to the first differential currents generated in the input circuit stage 320. The fourth circuit stage 332 may be a circuit that controls the gate voltage of the second output transistor MNO according to the second differential currents generated in the input circuit stage 320.

The third circuit stage 331 and the fourth circuit stage 332 may each be configured as current mirror circuits, so that the two circuit stages may be combined and referred to as current mirror circuit stages 331, 332, and the third circuit stage 331 may be referred to as the first current mirror circuit stage, and the fourth circuit stage 332 may be referred to as the second current mirror circuit stage. Hereinafter, the third circuit stage 331 will be referred to as the first current mirror circuit stage, and the fourth circuit stage 332 will be referred to as the second current mirror circuit stage, while describing an embodiment.

The fifth circuit stage 310 may be referred to as a boosting circuit stage, as a circuit that adds dynamic current to differential currents in response to fluctuations in differential input voltages. Hereinafter, the fifth circuit stage 310 will be referred to as the boosting circuit stage, while describing an embodiment.

The sixth circuit stage 340 may be referred to as a bias circuit stage as a circuit that provides a bias current. Hereinafter, the sixth circuit stage 340 will be referred to as a bias circuit stage and an embodiment will be described.

In the differential amplifier 300, the input circuit stage 320, the current mirror circuit stages 331, 332, the bias circuit stage 3340, and the output circuit stage 350 may form a rail-to-rail class-AB amplifier.

The differential amplifier 300 may include a first voltage rail to which a first driving voltage DDVDH is supplied and a second voltage rail to which a second driving voltage AVSS is supplied. The first driving voltage DDVDH may be greater than the second driving voltage AVSS. The input circuit stage 320, the current mirror circuit stage 331, 332, and the output circuit stage 350 may have one side connected to the first voltage rail and the other side connected to the second voltage rail.

The differential amplifier 300 may receive differential input voltages IP, IM and supply an output voltage OT to the outside. In the differential amplifier 300, a first differential input voltage IP may be input through a first input terminal, and a second differential input voltage IM may be input through a second input terminal. In the differential amplifier 300, an output voltage OT may be supplied to the outside through an output terminal. For convenience of explanation, the reference symbol IP may be used to refer to the first differential input voltage and may be used to refer to the first input terminal. The reference symbol IM may be used to refer to the second differential input voltage and may be used to refer to the second input terminal. The reference symbol OT can be used to refer to an output voltage and can be used to refer to an output terminal. The first differential input voltage IP can be referred to as a positive input voltage, and the first input terminal can be referred to as a positive input terminal. The second differential input voltage IM can be referred to as a negative input voltage, and the second input terminal can be referred to as a negative input terminal.

When the differential amplifier 300 functions as a buffer, the negative input terminal can be connected to the output terminal. The output voltage OT can follow the waveform of the first differential input voltage IP.

The speed at which the output voltage OT follows the waveform of the first differential input voltage IP can vary depending on the slew rate of the differential amplifier 300. The differential amplifier 300 according to the embodiment can improve the slew rate of the differential amplifier 300 by additionally supplying dynamic current through the boosting circuit stage 310. The dynamic current can occur in response to a change in the differential input voltages - particularly, the first differential input voltage IP. For example, when the first differential input voltage IP has a rising waveform or a falling waveform, the dynamic current can occur. The dynamic current may not occur when the differential input voltages - particularly, the first differential input voltage IP - are in a static state. For example, the dynamic current may not occur when the first differential input voltage IP is maintained at a constant level. According to this structure, the differential amplifier 300 can improve the slew rate without additionally consuming static power.

The output circuit stage 350 may include a first output transistor MPO connected between a first voltage rail and an output terminal and a second output transistor MNO connected between a second voltage rail and an output terminal. The slew rate of the differential amplifier 300 may be greatly affected by the magnitude of the current that charges and discharges the gate terminals of the first output transistor MPO and the second output transistor MNO. For example, the magnitude of the current flowing to the first output transistor MPO and the second output transistor MNO may be adjusted in response to the dynamic waveform of the first differential input voltage IP. To this end, when the voltage of the gate terminal is increased or decreased, if the current that charges and discharges the gate terminal is large, the fluctuation of the current flowing to the first output transistor MPO and the second output transistor MNO may increase, thereby improving the slew rate.

The differential amplifier 300 according to the embodiment may have a structure in which, in response to the variation of differential input voltages, it additionally supplies dynamic current, and this dynamic current increases the current that charges and discharges the gate terminals of the first output transistor MPO and the second output transistor MNO.

The current that charges and discharges the first output transistor MPO and the second output transistor MNO may be affected by the current of the input circuit stage 320 and the current of the current mirror circuit stage 331, 332. The differential amplifier 300 may additionally supply dynamic current to the input circuit stage 320 and/or the current mirror circuit stage 331, 332 to increase the current that charges and discharges the first output transistor MPO and the second output transistor MNO.

The input circuit stage 320 may include a first differential amplifier circuit 321 and a second differential amplifier circuit 322.

The first differential amplifier circuit 321 may include a first N-type transistor MN1 and a second N-type transistor MN2 having a common source structure. The source terminals of each of the first N-type transistor MN1 and the second N-type transistor MN2 may be connected to a second voltage rail to which a second driving voltage AVSS is supplied through a third N-type transistor MN3.

A bias voltage may be supplied to a gate terminal of the third N-type transistor MN3. Depending on the bias voltage, the third N-type transistor MN3 may function as a bias current source.

A first differential input voltage IP may be supplied to a gate terminal of the first N-type transistor MN1, and a second differential input voltage IM may be supplied to a gate terminal of the second N-type transistor MN2. When the first differential input voltage IP and the second differential input voltage IM are the same, 0.5 unit current (0.5I) can flow to the first N-type transistor MN1 and 0.5 unit current (0.5I) can flow to the second N-type transistor MN2.

When the first differential input voltage IP increases, more current can flow to the first N-type transistor MN1. When more current flows to the first N-type transistor MN1, more current flows to the first output transistor MPO and less current flows to the second output transistor MNO, so that the output voltage OT can increase.

When the first differential input voltage IP decreases, less current can flow to the first N-type transistor MN1. When less current flows into the first N-type transistor MN1, less current flows into the first output transistor MPO and more current flows into the second output transistor MNO, so that the output voltage OT may decrease.

The second differential amplifier circuit 322 may include a first P-type transistor MP1 and a second P-type transistor MP2 having a common source structure. The source terminals of each of the first P-type transistor MP1 and the second P-type transistor MP2 may be connected to a first voltage rail to which a first driving voltage DDVDH is supplied through a third P-type transistor MP3.

A bias voltage can be supplied to the gate terminal of the third P-type transistor MP3, and according to this bias voltage, the third P-type transistor MP3 can function as a bias current source.

A first differential input voltage IP can be supplied to the gate terminal of the first P-type transistor MP1, and a second differential input voltage IM can be supplied to the gate terminal of the second P-type transistor MP2. When the first differential input voltage IP and the second differential input voltage IM are the same, 0.5 unit current (0.5I) can flow to the first P-type transistor MP1, and 0.5 unit current (0.5I) can flow to the second P-type transistor MP2.

When the first differential input voltage IP increases, less current can flow to the first P-type transistor MP1. When less current flows to the first P-type transistor MP1, more current flows to the first output transistor MPO and less current flows to the second output transistor MNO, so that the output voltage OT can increase.

When the first differential input voltage IP decreases, more current can flow to the first P-type transistor MP1. When more current flows into the first P-type transistor MP1, less current flows into the first output transistor MPO and more current flows into the second output transistor MNO, so that the output voltage OT may decrease.

The current mirror circuit stage 331, 332 may include a first current mirror circuit stage 331 and a second current mirror circuit stage 332.

The first current mirror circuit stage 331 may include a first reference current transistor MP4 and a first mirroring current transistor MP5.

The first current mirror circuit stage 331 may have a common gate structure. The gate terminal of the first reference current transistor MP4 may be connected to the gate terminal of the first mirroring current transistor MP5.

The first current mirror circuit stage 331 may be connected to a first voltage rail to which a first driving voltage DDVDH is supplied on one side. The source terminal of the first reference current transistor MP4 and the source terminal of the first mirroring current transistor MP5 may be connected to the first voltage rail.

The first reference current may flow through the first reference current transistor MP4, and the mirroring current for the first reference current may flow through the first mirroring current transistor MP5.

A first additional transistor circuit having a common gate structure may be connected to the drain terminal of the first reference current transistor MP4 and the drain terminal of the first mirroring current transistor MP5.

The first additional transistor circuit may include a first additional transistor MP6 connected to a drain terminal of a first reference current transistor MP4 and a second additional transistor MP7 connected to a drain terminal of a first mirroring current transistor MP5. The first additional transistor MP6 may perform an additional function, such as limiting an amount of current flowing to the first reference current transistor MP4, and the second additional transistor MP7 may perform an additional function, such as limiting an amount of current flowing to the first mirroring current transistor MP5.

In order to configure the current mirror circuit, the gate terminal and the drain terminal of the first reference current transistor MP4 may be electrically connected. In normal operation, the first additional transistor MP6 and the second additional transistor MP7 may operate as a bypass circuit, so that the gate terminal of the first reference current transistor MP4 and the drain terminal of the first additional transistor MP6 may be connected.

In the first differential amplifier circuit 321 of the input circuit stage 320, the drain terminal of the first N-type transistor MN1 may be connected to the drain terminal of the first mirroring current transistor MP5. In the first differential amplifier circuit 321, the drain terminal of the second N-type transistor MN2 may be connected to the drain terminal of the first reference current transistor MP4.

The second current mirror circuit stage 332 may include the second reference current transistor MN4 and the second mirroring current transistor MN5.

The second current mirror circuit stage 332 may have a common gate structure. The gate terminal of the second reference current transistor MN4 may be connected to the gate terminal of the second mirroring current transistor MN5.

The second current mirror circuit stage 332 may be connected to a second voltage rail to which a second driving voltage AVSS is supplied at one side. The source terminal of the second reference current transistor MN4 and the source terminal of the second mirroring current transistor MN5 may be connected to the second voltage rail.

The second reference current may flow through the second reference current transistor MN4, and the mirroring current for the second reference current may flow through the second mirroring current transistor MN5.

A second additional transistor circuit having a common gate structure may be connected to the drain terminal of the second reference current transistor MN4 and the drain terminal of the second mirroring current transistor MN5.

The second additional transistor circuit may include a third additional transistor MN6 connected to the drain terminal of the second reference current transistor MN4 and a fourth additional transistor MN7 connected to the drain terminal of the second mirroring current transistor MN5. The third additional transistor MN6 may perform an additional function, such as limiting the amount of current flowing to the second reference current transistor MN4, and the fourth additional transistor MN7 may perform an additional function, such as limiting the amount of current flowing to the second mirroring current transistor MN5.

The gate terminal and the drain terminal of the second reference current transistor MN4 may be electrically connected to form the current mirror circuit. In normal operation, the third additional transistor MN6 and the fourth additional transistor MN7 may operate as a bypass circuit, so that the gate terminal of the second reference current transistor MN4 and the drain terminal of the third additional transistor MN6 may be connected.

In the second differential amplifier circuit 322 of the input circuit stage 320, the drain terminal of the first P-type transistor MP1 may be connected to the drain terminal of the second mirroring current transistor MN5. In the second differential amplifier circuit 322, the drain terminal of the second P-type transistor MP2 may be connected to the drain terminal of the second reference current transistor MN4.

A bias circuit stage 340 may be connected between the first current mirror circuit stage 331 and the second current mirror circuit stage 332.

The bias circuit stage 340 may include a first bias circuit and a second bias circuit.

The first bias circuit may have a structure in which one N-type transistor MN8 and one P-type transistor MP8 are connected in parallel. The bias current supplied by the first bias circuit can be determined according to the bias voltage supplied to the gate of one N-type transistor MN8 and one P-type transistor MP8.

The second bias circuit may have a structure in which another N-type transistor MN9 and another P-type transistor MP9 are connected in parallel. The bias current supplied by the second bias circuit can be determined according to the bias voltage supplied to the gate of the other N-type transistor MN9 and another P-type transistor MP9.

The first bias circuit may form one current path while being electrically connected to the first reference current transistor MP4 of the first current mirror circuit stage 331 and the second reference current transistor MN4 of the second current mirror circuit stage 332. This path may be called a reference current path. In the reference current path, the first bias current basically formed by the first bias circuit can flow through the first voltage rail, the first reference current transistor MP4, and the first bias circuit to the second voltage rail through the second reference current transistor MN4.

The second bias circuit can form another current path while being electrically connected to the first mirroring current transistor MP5 of the first current mirror circuit stage 331 and the second mirroring current transistor MN5 of the second current mirror circuit stage 332. This path can be called a mirroring current path. In the mirroring current path, the second bias current basically formed by the second bias circuit can flow through the first voltage rail, the first mirroring current transistor MP5, and the second bias circuit to the second voltage rail through the second mirroring current transistor MN5.

In the output circuit stage 350, the first output transistor MPO may have a source connected to the first voltage rail and a drain terminal connected to the output terminal OT. The gate terminal of the first output transistor MPO may be connected to the contact node of the second bias circuit and the first current mirror circuit stage 331 in the mirroring current path.

In the output circuit stage 350, the second output transistor MNO may have a source connected to the second voltage rail and a drain terminal connected to the output terminal OT. The gate terminal of the second output transistor MNO may be connected to the contact node of the second bias circuit and the second current mirror circuit stage 332 in the mirroring current path.

The input circuit stage 320 may generate differential currents according to the differential input voltages IP, IM. The current mirror circuit stage 331, 332 can control the gate voltage of the first output transistor MPO and the second output transistor MNO according to the differential currents.

The boosting circuit stage 310 can supply additional dynamic current to the input circuit stage 320 in response to the variation of the differential input voltages IP, IM or can improve the slew rate of the differential amplifier 300 by supplying additional dynamic current to the current mirror circuit stage 331, 332.

The boosting circuit stage 310 can supply dynamic current to the input circuit stage 320. The input circuit stage 320 can include differential amplifier circuits having a common source structure and having differential input voltages IP, IM input to gate terminals. The boosting circuit stage 310 can supply dynamic current to the common source terminal of the differential amplifier circuits. For example, the boosting circuit stage 310 can supply dynamic current to the common source terminal CSN of the first differential amplifier circuit 321 or to the common source terminal CSP of the second differential amplifier circuit 322.

The boosting circuit stage 310 may supply dynamic current to the current mirror circuit stages 331, 332. The current mirror circuit stages 331, 332 may include current mirror circuits having a common gate structure. The boosting circuit stage 310 may supply dynamic current to the common gate terminal of the current mirror circuits. For example, the boosting circuit stage 310 may supply dynamic current to the common gate terminal HPC of the first current mirror circuit stage 331 or to the common gate terminal HNC of the second current mirror circuit stage 332.

The current mirror circuit stages 331, 332 may include a reference current path through which a reference current flows and a mirroring current path through which a mirroring current flow. The boosting circuit stage 310 may supply dynamic current to the reference current path. For example, the boosting circuit stage 320 may supply dynamic current to the common gate terminal HPC of the first current mirror circuit stage 331. The dynamic current may flow into the reference current path through the drain terminal of the first reference current transistor MP4. As another example, the boosting circuit stage 320 may supply dynamic current to the common gate terminal HNC of the second current mirror circuit stage 332. Dynamic current can flow into the reference current path through the drain terminal of the second reference current transistor MN4.

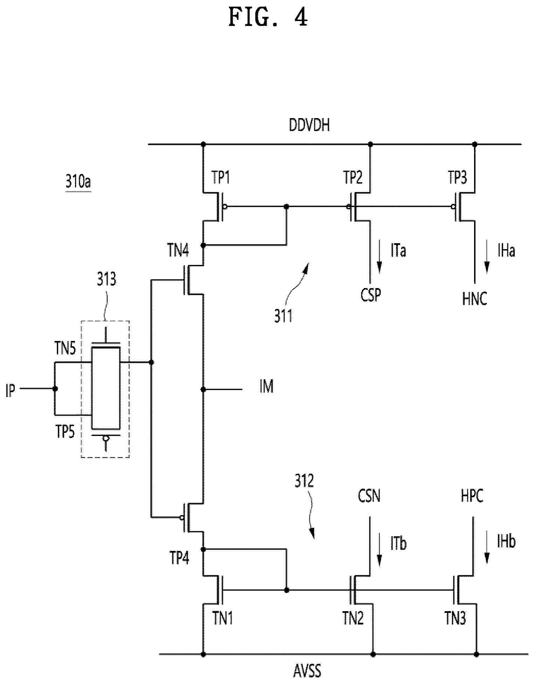

FIG. 4 is a first exemplary configuration diagram of a boosting circuit stage according to an embodiment.

Referring to FIG. 4, the boosting circuit stage 310a may include a first comparison transistor TN4 and a second comparison transistor TP4 in which a first differential input voltage IP is connected to a gate terminal and a second differential input voltage IM is connected to a source terminal.

The boosting circuit stage 310a may generate and supply a dynamic current according to the current flowing through the first comparison transistor TN4 and the second comparison transistor TP4.

The first comparison transistor TN4 may be an N-type transistor. If the first differential input voltage IP and the second differential input voltage IM maintain similar voltage levels, current may not flow through the first comparison transistor TN4. Then, when the first differential input voltage IP rises - having a rising waveform -, current can flow to the first comparison transistor TN4. The first comparison transistor TN4 can be connected to the first mirror circuit 311. The boosting circuit stage 310a can mirror the current flowing to the first comparison transistor TN4 through the first mirror circuit 311 and supply the mirrored current to the common source terminal CSP of the second differential amplifier circuit and/or the common gate terminal HNC of the second current mirror circuit stage 332.

The current flowing to the first comparison transistor TN4 in the first mirror circuit 311 can flow to the P-type transistor TP1, and the current flowing to the P-type transistor TP1 can be mirrored to the other P-type transistor TP2 and the other P-type transistor TP3. The current ITa flowing in the other P type transistor TP2 may be supplied to the common source terminal CSP of the second differential amplifier circuit, and the current IHa flowing in the other P type transistor TP3 may be supplied to the common gate terminal HNC of the second current mirror circuit stage 332.

The second comparison transistor TP4 may be a P type transistor. If the first differential input voltage IP and the second differential input voltage IM maintain similar voltage levels, current may not flow to the second comparison transistor TP4. Then, if the first differential input voltage IP decreases - if it has a falling waveform -, current may flow to the second comparison transistor TP4. The second comparison transistor TP4 may be connected to the second mirror circuit 312. The boosting circuit stage 310a can mirror the current flowing to the second comparison transistor TP4 through the second mirror circuit 312, and supply the mirrored current to the common source terminal CSN of the first differential amplifier circuit and/or the common gate terminal HPC of the first current mirror circuit stage 331.

The current flowing to the second comparison transistor TP4 in the second mirror circuit 312 can flow to an N-type transistor TN1, and the current flowing to the N-type transistor TN1 can be mirrored to another N-type transistor TN2 and another N-type transistor TN3. The current ITb flowing in the other N-type transistor TN2 may be supplied to the common source terminal CSN of the first differential amplifier circuit, and the current IHb flowing in the other N-type transistor TN3 may be supplied to the common gate terminal HPC of the first current mirror circuit stage 331.

The boosting circuit stage 310a may include a toggle circuit 313 in which an N-type transistor TN5 and a P-type transistor TP5 are connected in parallel. The toggle circuit 313 may be connected between a terminal to which a first differential input voltage IP is input and the gate terminals of the comparison transistors TN4, TP4. The boosting circuit stage 310a may control the voltage supplied to the gate terminal of the toggle circuit 313 to turn off the toggle circuit 313 and prevent dynamic current from being supplied.

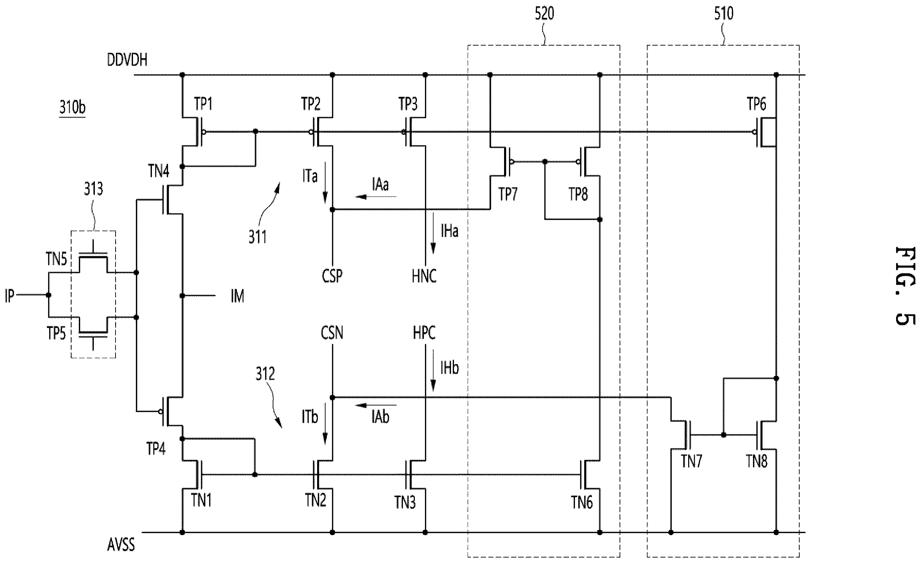

FIG. 5 is a second exemplary configuration diagram of a boosting circuit stage according to an embodiment.

Referring to FIG. 5, the boosting circuit stage 310b may include a first comparison transistor TN4 and a second comparison transistor TP4 in which a first differential input voltage IP is connected to a gate terminal and a second differential input voltage IM is connected to a source terminal.

The boosting circuit stage 310b may generate and supply a dynamic current according to the current flowing through the first comparison transistor TN4 and the second comparison transistor TP4.

The first comparison transistor TN4 may be an N-type transistor. If the first differential input voltage IP and the second differential input voltage IM maintain similar voltage levels, current may not flow through the first comparison transistor TN4. Then, when the first differential input voltage IP rises - having a rising waveform -, current can flow to the first comparison transistor TN4. The first comparison transistor TN4 can be connected to the first mirror circuit 311. The boosting circuit stage 310b can mirror the current flowing to the first comparison transistor TN4 through the first mirror circuit 311 and supply the mirrored current to the common source terminal CSP of the second differential amplifier circuit and/or the common gate terminal HNC of the second current mirror circuit stage 332.

The current flowing to the first comparison transistor TN4 in the first mirror circuit 311 can flow to the P-type transistor TP1, and the current flowing to the P-type transistor TP1 can be mirrored to the other P-type transistor TP2 and the other P-type transistor TP3. The current ITa flowing in the other P type transistor TP2 may be supplied to the common source terminal CSP of the second differential amplifier circuit, and the current IHa flowing in the other P type transistor TP3 may be supplied to the common gate terminal HNC of the second current mirror circuit stage 332.

The second comparison transistor TP4 may be a P type transistor. If the first differential input voltage IP and the second differential input voltage IM maintain similar voltage levels, current may not flow to the second comparison transistor TP4. Then, if the first differential input voltage IP decreases - if it has a falling waveform -, current may flow to the second comparison transistor TP4. The second comparison transistor TP4 may be connected to the second mirror circuit 312. The boosting circuit stage 310b can mirror the current flowing to the second comparison transistor TP4 through the second mirror circuit 312, and supply the mirrored current to the common source terminal CSN of the first differential amplifier circuit and/or the common gate terminal HPC of the first current mirror circuit stage 331.

The current flowing to the second comparison transistor TP4 in the second mirror circuit 312 can flow to an N-type transistor TN1, and the current flowing to the N-type transistor TN1 can be mirrored to another N-type transistor TN2 and another N-type transistor TN3. The current ITb flowing in the other N-type transistor TN2 may be supplied to the common source terminal CSN of the first differential amplifier circuit, and the current IHb flowing in the other N-type transistor TN3 may be supplied to the common gate terminal HPC of the first current mirror circuit stage 331.

The boosting circuit stage 310b may include a toggle circuit 313 in which an N-type transistor TN5 and a P-type transistor TP5 are connected in parallel. The toggle circuit 313 may be connected between a terminal to which a first differential input voltage IP is input and the gate terminals of the comparison transistors TN4, TP4. The boosting circuit stage 310b may control the voltage supplied to the gate terminal of the toggle circuit 313 to turn off the toggle circuit 313 and prevent dynamic current from being supplied.

The boosting circuit stage 310b may include a third mirror circuit 510.

The first mirror circuit 311 may include a first reference current transistor TP1 and a first mirroring current transistor TP2 that mirrors the current flowing through the first reference current transistor TP1.

The current flowing through the first comparison transistor TN4 flows through the first reference current transistor TP1, and the first mirroring current transistor TP2 may generate a first mirroring current for the first comparison transistor TN4 by mirroring the current flowing through the first reference current transistor TP1. A first dynamic current ITa corresponding to the first mirroring current may be supplied to a common source terminal CSP of the second differential amplifier circuit. The first dynamic current ITa may be added to the second differential currents generated by the second differential amplifier circuit and may be used for gate control of the second output transistor.

The third mirror circuit 510 may include a second mirroring current transistor TP6 that mirrors the current flowing in the first reference current transistor TP1 and transistors TN7, TN8 that mirror the current of the second mirroring current transistor TP6. A second dynamic current IAb corresponding to the second mirroring current formed in the second mirroring current transistor TP6 may be supplied to the common source terminal CSN of the first differential amplifier circuit. The second dynamic current IAb may be added to the first differential currents generated by the first differential amplifier circuit and may be used for gate control of the first output transistor.

According to this circuit, the boosting circuit stage 310b may boost-control not only the second output transistor connected to the lower side of the output circuit stage but also the first output transistor connected to the upper side. Current may flow to the first comparison transistor TN4 at the rising edge of the first differential input voltage IP. In this respect, the boosting circuit stage 310b can rapidly turn on the first output transistor and rapidly turn off the second output transistor in response to the rising edge of the first differential input voltage IP.

The first mirror circuit 311 may include a third mirroring current transistor TP3 that mirrors the current flowing in the first reference current transistor TP1. The third mirroring current transistor TP3 may generate a third mirroring current for the first comparison transistor TN4 by mirroring the current flowing in the first reference current transistor TP1. A third dynamic current IHa corresponding to the third mirroring current may be additionally supplied to the common gate terminal HNC of the second current mirror circuit stage 332.

The boosting circuit stage 310b may include a fourth mirror circuit 520.

The second mirror circuit 312 may include a first reference current transistor TN1 and a first mirroring current transistor TN2 that mirrors the current flowing in the first reference current transistor TN1.

The current flowing in the second comparison transistor TP4 may flow in the first reference current transistor TN1. The first mirroring current transistor TN2 may generate a fourth mirroring current for the second comparison transistor TP4 by mirroring the current flowing in the first reference current transistor TN1. A fourth dynamic current ITb corresponding to the fourth mirroring current may be supplied to the common source terminal CSN of the first differential amplifier circuit. The fourth dynamic current ITb may be added to the first differential currents generated by the first differential amplifier circuit and may be used for gate control of the first output transistor.

The fourth mirror circuit 520 may include a second mirroring current transistor TN6 that mirrors the current flowing in the first reference current transistor TN1 and transistors TP7, TP8 that mirror the current of the second mirroring current transistor TN6. A fifth dynamic current IAa corresponding to the fifth mirroring current formed in the second mirroring current transistor TN6 may be supplied to the common source terminal CSP of the second differential amplifier circuit. The fifth dynamic current IAa may be added to the second differential currents generated by the second differential amplifier circuit and may be used for gate control of the second output transistor.

According to this circuit, the boosting circuit stage 310b may boost-control not only the first output transistor connected to the upper side of the output circuit stage but also the second output transistor connected to the lower side. Current may flow to the second comparison transistor TP4 at the falling edge of the first differential input voltage IP. In this aspect, the boosting circuit stage 310b can rapidly turn on the first output transistor and rapidly turn off the second output transistor in response to the falling edge of the first differential input voltage IP.

The second mirror circuit 312 may include a third mirroring current transistor TN3 that mirrors the current flowing in the first reference current transistor TN1. The third mirroring current transistor TN3 can generate a sixth mirroring current for the second comparison transistor TP4 by mirroring the current flowing in the first reference current transistor TN1. A sixth dynamic current IHb corresponding to the sixth mirroring current can be additionally supplied to the common gate terminal HPC of the first current mirror circuit stage 331.

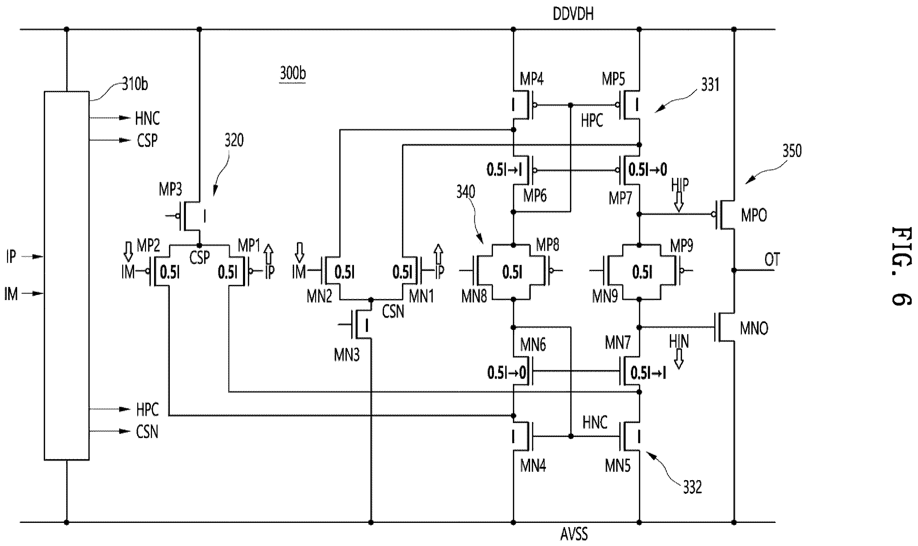

FIG. 6 is a diagram illustrating the main current state of the differential amplifier for the rising waveform when the boosting circuit stage according to the second example is turned off.

Referring to FIG. 6, the boosting circuit stage 310b may turn off the toggle circuit so as not to supply dynamic current. At this time, the differential amplifier 300b may operate according to the operation of the rail-to-rail class-AB amplifier.

When the first differential input voltage IP has a rising waveform, the current of the first N-type transistor MN1 may increase. Accordingly, the current of the first mirroring current transistor MP5 flows to the first N-type transistor MN1, and the gate terminal HIP of the first output transistor MPO may discharge according to the second bias current by the second bias circuit.

When the first differential input voltage IP has a rising waveform, the current of the first P-type transistor MP1 may decrease. Accordingly, the current of the second mirroring current transistor MN5 may not flow to the first P-type transistor MP1 and discharge the gate terminal HIN of the second output transistor MNO.

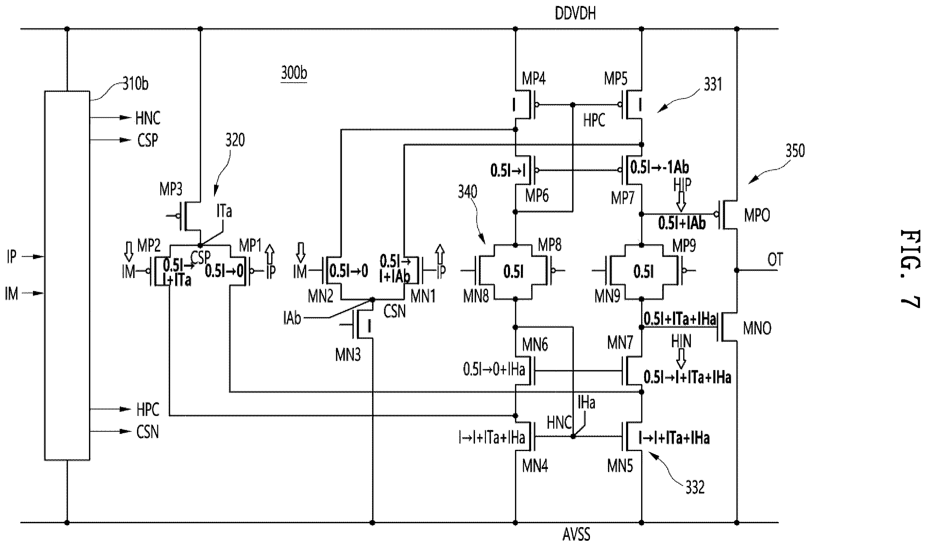

FIG. 7 is a diagram illustrating the main current state of the differential amplifier for the rising waveform when the boosting circuit stage according to the second example is turned on.

Referring to FIG. 7, the boosting circuit stage 310b may turn on the toggle circuit to supply dynamic current.

When the first differential input voltage IP has a rising waveform, as described with reference to FIG. 5, the boosting circuit stage 310b can supply the first dynamic current ITa to the common source terminal CSP of the second differential amplifier circuit, supply the second dynamic current IAb to the common source terminal CSN of the first differential amplifier circuit, and supply the third dynamic current IHa to the common gate terminal HNC of the second current mirror circuit stage 332. Accordingly, the gate terminal of the second output transistor MNO can be discharged with a current in which the first dynamic current ITa and the third dynamic current IHa are added to the existing discharge current. The gate terminal of the first output transistor MPO can be charged with a current in which the second dynamic current IAb is added to the existing charge current. Accordingly, the slew rate of the output circuit stage 350 can be improved.

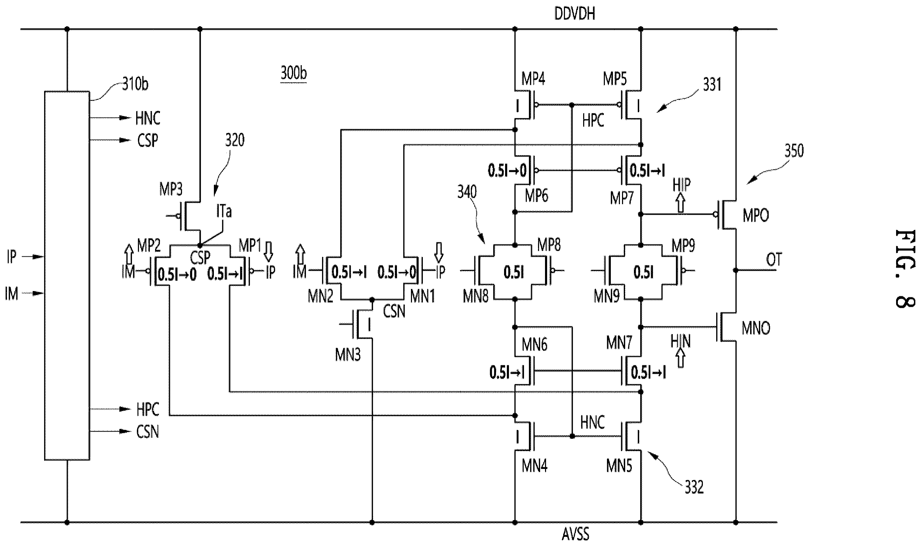

FIG. 8 is a diagram illustrating the main current state of the differential amplifier for the falling waveform when the boosting circuit stage according to the second example is turned off.

Referring to FIG. 8, the boosting circuit stage 310b may turn off the toggle circuit so as not to supply dynamic current. At this time, the differential amplifier 300b may operate according to the operation of the rail-to-rail class-AB amplifier.

When the first differential input voltage IP has a falling waveform, the current of the first N-type transistor MN1 may decrease. Accordingly, the current of the first mirroring current transistor MP5 may not flow to the first N-type transistor MN1 and may charge the gate terminal HIP of the first output transistor MPO.

When the first differential input voltage IP has a falling waveform, the current of the first P-type transistor MP1 may increase. Accordingly, the current of the second mirroring current transistor MN5 flows to the first P-type transistor MP1, and the gate terminal HIN of the second output transistor MNO can be charged according to the second bias current by the second bias circuit.

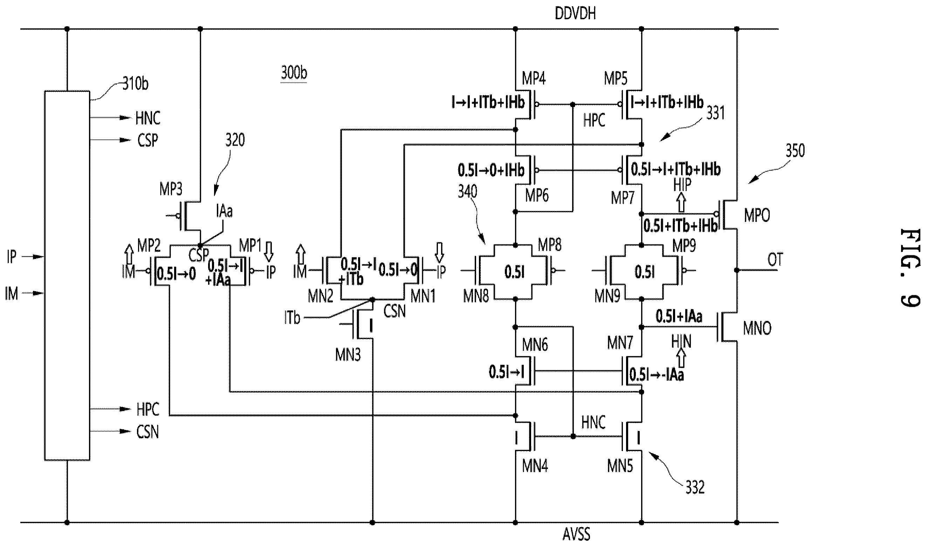

FIG. 9 is a diagram illustrating the main current state of the differential amplifier for the falling waveform when the boosting circuit stage according to the second example is turned on.

Referring to FIG. 9, the boosting circuit stage 310b can supply dynamic current by turning on the toggle circuit.

When the first differential input voltage IP has a falling waveform, as described with reference to FIG. 5, the boosting circuit stage 310b can supply the fourth dynamic current ITb to the common source terminal CSN of the first differential amplifier circuit, the fifth dynamic current IAa to the common source terminal CSP of the second differential amplifier circuit, and the sixth dynamic current IHb to the common gate terminal HPC of the first current mirror circuit stage 331. Accordingly, the gate terminal of the first output transistor MPO can be charged with a current in which the fourth dynamic current ITb and the sixth dynamic current IHb are added to the existing charging current. The gate terminal of the second output transistor MNO can be discharged with a current in which the fifth dynamic current IAa is added to the existing discharging current. Accordingly, the slew rate of the output circuit stage 350 can be improved.

As described above, according to the embodiment, the response characteristics of the display panel can be improved through improvements to the data driving device.

According to the embodiment, the slew rate of the differential amplifier that can be used in the data driving device can be improved.

According to the embodiment, a differential amplifier having a high-speed slew rate can be provided without adding static power.

According to the embodiment, a differential amplifier in which the phenomenon of overshooting and undershooting is improved in the range of linear operation can be provided.

According to the embodiment, a differential amplifier in which an effective slew boosting function is performed by adding a simple circuit can be provided.

The above detailed description should not be construed as limiting in all respects and should be considered as illustrative. The scope of the embodiment should be determined by a reasonable interpretation of the appended claims, and all changes within the equivalent scope of the embodiment are included in the scope of the embodiment.

## Claims

1. A differential amplifier comprising:
a first circuit stage including a first output transistor connected between a first voltage rail and an output terminal, and a second output transistor connected between a second voltage rail and the output terminal;
a second circuit stage configured to generate first differential currents and second differential currents based on differential input voltages;
a third circuit stage configured to control a gate voltage of the first output transistor based on the first differential currents;
a fourth circuit stage configured to control a gate voltage of the second output transistor based on the second differential currents; and
a fifth circuit stage configured to add dynamic currents to the first and second differential currents in response to variations in the differential input voltages.

2. The differential amplifier of claim 1,
wherein the second circuit stage has a common source structure, and includes a first differential amplifier circuit and a second differential amplifier circuit each having gate terminals to which the differential input voltages are inputted, and
wherein the fifth circuit stage is configured to supply dynamic currents to respective common source terminals of the first and second differential amplifier circuits.

3. The differential amplifier of claim 2, further comprises a first bias current source configured to supply a bias current to the common source terminal of the first differential amplifier circuit,
wherein the first bias current source and the fifth circuit stage are configured to supply currents in parallel to the common source terminal of the first differential amplifier circuit.

4. The differential amplifier of claim 1, wherein the fifth circuit stage includes a comparison transistor having a gate terminal to which a first differential input voltage is inputted and a source terminal to which a second differential input voltage is inputted, and
wherein the fifth circuit stage is configured to generate the dynamic current based on a current flowing through the comparison transistor.

5. The differential amplifier of claim 4, wherein the fifth circuit stage further includes a mirror circuit configured to generate a first mirror current and a second mirror current by mirroring the current of the comparison transistor,
wherein a first dynamic current corresponding to the first mirror current is added to the second differential currents, and a second dynamic current corresponding to the second mirror current is added to the first differential currents.

6. The differential amplifier of claim 5, wherein the mirror circuit is further configured to generate a third mirror current by mirroring the current of the comparison transistor, and
wherein a third dynamic current corresponding to the third mirror current is additionally supplied to the fourth circuit stage.

7. The differential amplifier of claim 1,
wherein another dynamic current is additionally supplied to the third or fourth circuit stage in response to variations in the differential input voltages.

8. The differential amplifier of claim 7,
wherein the third and fourth circuit stages each include a reference current path through which a reference current flow and a mirroring current path through which a mirrored current flow, and
wherein the fifth circuit stage is configured to supply the another dynamic current to the reference current path.

9. The differential amplifier of claim 7,
wherein the third and fourth circuit stages include a current mirror circuit stage having a common gate structure, and
wherein the fifth circuit stage is configured to supply the dynamic current to a common gate terminal of the current mirror circuit stage.

10. The differential amplifier of claim 7,
wherein the third circuit stage is connected to the first voltage rail supplying a first driving voltage, and the fourth circuit stage is connected to the second voltage rail supplying a second driving voltage, and
wherein the fifth circuit stage is configured to supply the another dynamic current to the third circuit stage or the fourth circuit stage depending on a polarity of the differential voltage between the differential input voltages.

11. The differential amplifier of claim 4, wherein a toggle circuit including an N-type transistor and a P-type transistor connected in parallel is connected between a terminal to which the first differential input voltage is inputted and the gate terminal of the comparison transistor.

12. The differential amplifier of claim 1,
wherein the fifth circuit stage includes a first comparison transistor having a gate terminal receiving a first differential input voltage and a source terminal receiving a second differential input voltage, and a second comparison transistor, and
wherein the dynamic current is supplied based on currents flowing through the first and second comparison transistors.

13. A data driving device comprising:
a latch circuit configured to latch pixel data including a gray level value for a pixel;
a digital-to-analog converter configured to convert a digital signal corresponding to the pixel data into an analog voltage; and
a buffer circuit:
including a rail-to-rail class-AB type amplifier having a first differential amplifier circuit and a second differential amplifier circuit, each having gate terminals to which differential input voltages are inputted, connected to an input circuit stage, and
configured to generate a data voltage amplifying the analog voltage using the amplifier, to supply the data voltage to the pixel, and
to supply dynamic currents to the first and second differential amplifier circuits in response to variations in the analog voltage.

14. The data driving device of claim 13, wherein the first and second differential amplifier circuits each have a common source structure, and
wherein the buffer circuit is configured to supply the dynamic currents to the common source terminals of the first and second differential amplifier circuits.

15. The data driving device of claim 13, wherein the buffer circuit is configured to additionally supply another dynamic current to a current mirror circuit stage of the amplifier.
